# EUROPEAN PATENT APPLICATION

(11) **EP 4 637 308 A1**
(43) Date of publication of application: **22.10.2025**
(21) Application number: 23959812.1
(22) Date of filing: 29.11.2023
(51) Int. Cl.: H10K 59/12

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: YU, Kai, Beijing 100176 (CN); ZHAO, Yongliang, Beijing 100176 (CN)
(74) Representative: Durán-Corretjer, S.L.P.
(86) International application number: PCT/CN2023/135226
(87) International publication number: WO 2025/111893

(57) **Abstract**

A display substrate and a manufacturing method therefor, and a display device. The display substrate comprises an active layer (21) provided on one side of a substrate (101); a first gate (11) provided on a first side of the active layer (21); a second gate (12) provided on a second side of the active layer (21), the second gate (12) being electrically connected to the active layer (21); and a third gate (13) provided on the second side of the active layer (21), the third gate (13) and the second gate (12) being insulated from each other, and the third gate (13) being electrically connected to the first gate (11). The first side and the second side are respectively two opposite sides of the active layer (21) in a direction perpendicular to the substrate (101), and the first gate (11), the second gate (12), and the third gate (13) all overlap with the orthographic projection of the active layer (21) on the substrate (101).

## Description

### Technical Field

The present disclosure relates to, but is not limited to, the field of display technologies, and particularly relates to a display substrate and a manufacturing method therefor, and a display apparatus.

### Background

An Organic Light Emitting Diode (OLED) and a Quantum dot Light Emitting Diode (QLED) are active light emitting display devices and have advantages such as self-luminescence, wide viewing angle, high contrast ratio, low power consumption, very high response speed, lightness and thinness, flexibility, and low cost. With the continuous development of display technologies, a flexible display apparatus (Flexible Display) in which an OLED or a QLED is used as a light emitting device and signal control is performed through a Thin Film Transistor (TFT) has become a mainstream product in the field of display at present.

### Summary

The following is a summary of subject matter described herein in detail. This summary is not intended to limit the protection scope of the claims.

In one aspect, an embodiment of the present disclosure provides a display substrate, which includes: an active layer, provided on a side of a base substrate; a first gate, provided on a first side of the active layer; a second gate, provided on a second side of the active layer, the second gate being electrically connected with the active layer; and a third gate, provided on the second side of the active layer, the third gate and the second gate being insulated from each other and the third gate being electrically connected with the first gate.

The first side and the second side are two opposite sides of the active layer in a direction perpendicular to the base substrate respectively. An orthographic projection of the first gate on the base substrate, an orthographic projection of the second gate on the base substrate, and an orthographic projection of the third gate on the base substrate are all overlapped with an orthographic projection of the active layer on the base substrate.

In an exemplary implementation, the orthographic projection of the second gate on the base substrate is not overlapped with the orthographic projection of the third gate on the base substrate, a partition region is provided between the orthographic projection of the second gate on the base substrate and the orthographic projection of the third gate on the base substrate, and the partition region is filled with an insulation material.

In an exemplary implementation, the second gate is located on a side of the third gate in a second direction, and a shape of the partition region is a line shape extending in a first direction; or, the second gate is located on a side of the third gate in the first direction, a shape of the partition region is a line shape extending in the second direction, and the first direction intersects with the second direction.

In an exemplary implementation, in a plane parallel to the display substrate, a vertical distance of the partition region in the second direction is greater than or equal to 0.5 micron and less than or equal to 2 microns.

In an exemplary implementation, the second gate is located on a side of the third gate in a first direction, a shape of the partition region is a line shape extending in a second direction, and the first direction intersects with the second direction.

In an exemplary implementation, in a plane parallel to the display substrate, a vertical distance of the partition region in the first direction is greater than or equal to 0.5 micron and less than or equal to 2 microns.

In an exemplary implementation, the partition region is in a bending line shape; or, the partition region is in a serpentine shape.

In an exemplary implementation, a signal line provided on the base substrate is further included, an orthographic projection of the signal line on the base substrate is overlapped with each of the orthographic projection of the second gate on the base substrate and the orthographic projection of the third gate on the base substrate, and the signal line includes at least one of an initialization signal line, a reference voltage signal line, and a power supply signal line.

In an exemplary implementation, an area of the orthographic projection of the second gate on the base substrate is greater than or equal to an area of the orthographic projection of the third gate on the base substrate.

In an exemplary implementation, a ratio of the area of the orthographic projection of the second gate on the base substrate to the area of the orthographic projection of the third gate on the base substrate is less than or equal to 2 and greater than or equal to 1.

In an exemplary implementation, an area of the orthographic projection of the second gate on the base substrate is less than or equal to an area of the orthographic projection of the third gate on the base substrate.

In an exemplary implementation, a ratio of the area of the orthographic projection of the second gate on the base substrate to the area of the orthographic projection of the third gate on the base substrate is less than or equal to 1 and greater than or equal to 0.1.

In an exemplary implementation, the second gate includes a conductive material with a high work function.

In an exemplary implementation, the second gate includes a second electrode part and a second lead part connected with each other, and the second lead part is electrically connected with the active layer.

In an exemplary implementation, the third gate includes a conductive material with a low work function, and the conductive material with the low work function includes at least one of aluminum, silver, and zinc.

In an exemplary implementation, the third gate includes a third electrode part and a third lead part connected with each other, and the third lead part is electrically connected with the first gate.

In an exemplary implementation, the first gate includes a first electrode part and a first lead part connected with the first electrode part, and the first lead part is electrically connected with the second gate.

In an exemplary implementation, a material of the active layer includes a metal oxide, the active layer includes a channel region, and a shape of the channel region is a straight line shape or an inverted U shape.

In an exemplary implementation, a first connection electrode is further included, the first connection electrode is disposed on a side of the active layer away from the base substrate, and the first connection electrode is connected with the second gate and the active layer.

In an exemplary implementation, a second connection electrode is further included, the second connection electrode is disposed on a side of the active layer away from the base substrate, and the second connection electrode is connected with the first gate and the third gate.

In another aspect, the present disclosure also provides a display apparatus, including the display substrate described above.

In another aspect, the present disclosure further provides a manufacturing method for a display substrate, including: forming a second gate and a third gate on a base substrate; forming an active layer on a side of the second gate and the third gate away from the base substrate; forming a first gate on a side of the active layer away from the base substrate, an orthographic projection of the first gate on the base substrate, an orthographic projection of the second gate on the base substrate, and an orthographic projection of the third gate on the base substrate being all overlapped with an orthographic projection of the active layer on the base substrate; and electrically connecting the second gate with the active layer and electrically connecting the third gate with the first gate.

Other aspects of the present disclosure may be comprehended after the drawings and the detailed description are read and understood.

### Brief Description of Drawings

The drawings are intended to provide understanding of technical solution of the present disclosure, and form a part of the specification. The drawings and embodiments of the present disclosure are used to explain the technical solution of the present disclosure, and do not form limitations on the technical solution of the present disclosure.
FIG. 1 is a schematic diagram of a structure of a display apparatus.
FIG. 2 is a schematic diagram of a planar structure of a display substrate.
FIG. 3 is a schematic diagram of a sectional structure of a display substrate.
FIG. 4a is a schematic diagram of a sectional structure of a transistor of a display substrate.
FIG. 4b is a graph of a starting current of a transistor of a display substrate.
FIG. 5a is an equivalent circuit diagram of a transistor of a display substrate according to an exemplary embodiment of the present disclosure.
FIG. 5b is an equivalent circuit diagram of a pixel drive circuit of a display substrate according to an exemplary embodiment of the present disclosure.
FIG. 5c is an operating timing diagram of a pixel drive circuit of a display substrate according to an exemplary embodiment of the present disclosure.
FIG. 6 is a schematic diagram of a sectional structure of a display substrate according to an exemplary embodiment of the present disclosure.
FIG. 7 is a schematic diagram of a planar structure of a display substrate according to an exemplary embodiment of the present disclosure.
FIG. 8 is a schematic diagram of a display substrate after a pattern of a second gate and a pattern of a third gate is formed according to the present disclosure.
FIGS. 9a and 9b are schematic diagrams of a display substrate after a pattern of an active layer is formed according to the present disclosure.
FIGS. 10a and 10b are schematic diagrams of a display substrate after a pattern of a first gate is formed according to the present disclosure.
FIGS. 11a and 11b are schematic planar diagrams of another display substrate according to the present disclosure.
FIGS. 12a and 12b are schematic planar diagrams of another display substrate according to the present disclosure.
FIG. 13 is a schematic planar diagram of another display substrate according to the present disclosure.
FIG. 14 is a schematic planar diagram of another display substrate according to the present disclosure.
FIG. 15 is a schematic planar diagram of another display substrate according to the present disclosure.

### Detailed Description

To make the objectives, technical solutions, and advantages of the present disclosure clearer, embodiments of the present disclosure will be described in detail hereinafter with reference to the drawings. It is to be noted that implementations may be implemented in multiple different forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", and the like in the specification are set not to form limits in numbers but only to avoid confusion between constituent elements.

In the specification, for convenience, expressions "central", "above", "below", "front", "back", "vertical", "horizontal", "top", "bottom", "inside", "outside", and the like for indicating directional or positional relationships are used to illustrate positional relationships between the constituent elements with reference to the drawings, not to indicate or imply that involved apparatuses or elements are required to have specific orientations or are structured and operated in the specific orientations but only to easily describe the present specification and simplify the description, and thus should not be understood as limitations on the present disclosure. The positional relationships between the constituent elements are changed as appropriate based on directions according to which each constituent element is described. Therefore, appropriate replacements based on situations are allowed, and the positional relationships are not limited to the expressions in the specification.

In the specification, unless otherwise explicitly specified and defined, terms "mounting", "coupling", and "connection" should be understood in a broad sense. For example, it may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the aforementioned terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. **It** is to be noted that in the specification, the channel region refers to a region through which a current mainly flows.

In the specification, a first electrode may be a drain electrode, and a second electrode may be a source electrode. Alternatively, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source end" and the "drain end", are interchangeable in the specification.

In the specification, "electrical connection" includes connection of constituent elements through an element with a certain electrical action. An "element with a certain electrical action" is not particularly limited as long as electrical signals may be sent and received between the connected constituent elements. Examples of the "element with a certain electrical action" not only include an electrode and a wiring, but also include a switching element such as a transistor, a resistor, an inductor, a capacitor, another element with various functions, or the like.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

Triangle, rectangle, trapezoid, pentagon, or hexagon and the like in this specification are not strictly defined, and they may be approximate triangle, rectangle, trapezoid, pentagon, hexagon and the like. There may be some small deformations caused by tolerance, and there may be chamfer, arc edge, deformation and the like.

In the present disclosure, "about" refers to that a boundary is not defined so strictly and numerical values within a range of process and measurement errors are allowed.

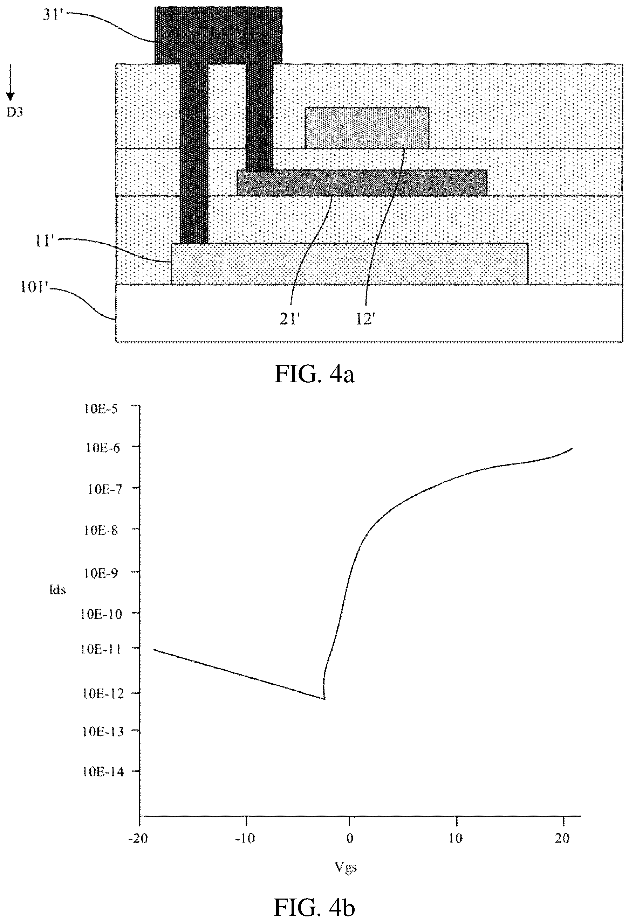

FIG. 4a is a schematic diagram of a sectional structure of a transistor of a display substrate. As shown in FIG. 4a, the display substrate includes a base substrate 101', a first gate 11' disposed on the base substrate 101', an active layer 21' disposed on a side of the first gate 11' away from the base substrate 101', a second gate 12' disposed on a side of the active layer 21' away from the base substrate 101', and a connection electrode 31' disposed on a side of the second gate 12' away from the base substrate 101'. An orthographic projection of the first gate 11' on the base substrate 101' and an orthographic projection of the second gate 12' on the base substrate 101' are both overlapped with an orthographic projection of the active layer 21' on the base substrate 101'. The first gate 11', the second gate 12', and the active layer 21' form a transistor and the transistor is with a double-gate structure. The first gate 11' may be used as a bottom gate of the transistor and the second gate 12' may be used as a top gate of the transistor. The connection electrode 31' connects the first gate 11' with a source end of the active layer 21' through a via.

The transistor in the display substrate has a large sub-threshold swing amplitude (SS), which is used to increase a data range, that is, a voltage amplitude that needs to be changed to change a current at a same level, thereby reducing a sensitivity of a light emission brightness of the display substrate to voltage fluctuations. If the data range is too small, that is, the sensitivity is too high, it will lead to poor low-grayscale stability (Mura) and affect the display effect.

FIG. 4b is a graph of a starting current of a transistor of a display substrate. In FIG. 4b, the abscissa is a voltage Vgs between the gate and the active layer and in FIG. 4b, the ordinate is a leakage current Ids of the active layer. As shown in FIG. 4b, in the double-gate structure of the transistor of the display substrate, the first gate 11' is connected to the source end of the active layer 21' by the connection electrode 31', so that the sub-threshold swing amplitude (SS) value may be significantly increased, but the starting current (Ion) of the transistor may be reduced, a switching ratio (ratio of the starting current to a closing current) of the transistor may be affected, and the display effect may be affected.

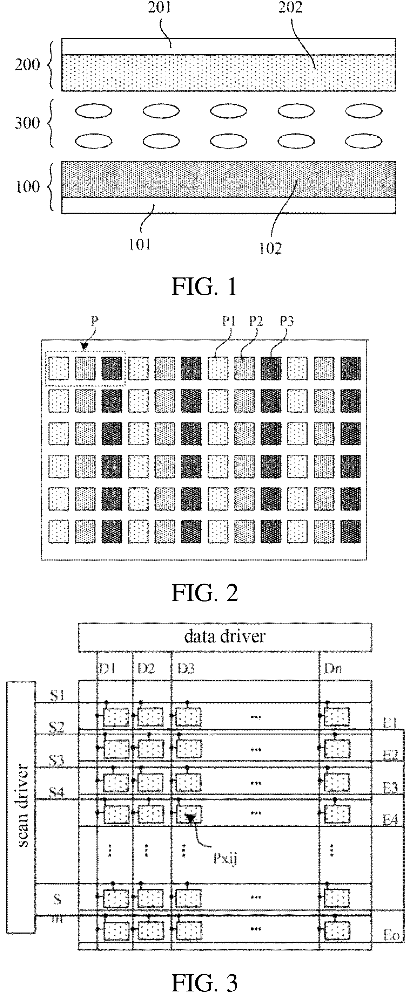

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with multiple data signal lines (D1 to Dn) respectively, the scan driver is connected with multiple scan signal lines (S1 to Sm) respectively, and the light emitting driver is connected with multiple light emitting signal lines (E1 to Eo) respectively. The pixel array may include multiple sub-pixels Pxij, i and j may be natural numbers, at least one sub-pixel Pxij may include a circuit unit and a light emitting unit, the circuit unit may include at least a pixel drive circuit connected to a scan signal line, a light emitting signal line and a data signal line, respectively. The light emitting unit may include a light emitting device connected to the pixel drive circuit of the circuit unit. In an exemplary implementation, the timing controller may provide the data driver with a gray scale value and a control signal which are suitable for the specification of the data driver, provide the scan driver with a clock signal and a scan start signal and the like which are suitable for the specification of the scan driver, and provide the light emitting driver with a clock signal and an emission stop signal and the like which are suitable for the specification of the light emitting driver. The data driver may generate data voltages to be provided to the data signal lines D1, D2, D3, ..., and Dn using the gray scale value and the control signal that are received from the timing controller. For example, the data driver may sample the gray scale value using the clock signal and apply a data voltage corresponding to the gray scale value to the data signal lines D1 to Dn by taking a pixel row as a unit, wherein n may be a natural number. The scan driver may generate scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may generate an emission signal to be provided to the light emitting signal lines E1, E2, E3, ..., and Eo by receiving a clock signal, an emission stop signal, or the like from the timing controller. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number. In an exemplary implementation, the pixel array may be provided on the display substrate.

FIG. 2 is a schematic diagram of a planar structure of a display substrate. In an exemplary implementation, the display substrate may include a display area and a bezel area located on a periphery of the display area. As shown in FIG. 2, the display area of the display substrate may include multiple pixel units P arranged in a matrix. At least one of the pixel units P may include a first sub-pixel P1 emitting light in a first color, a second sub-pixel P2 emitting light in a second color, and a third sub-pixel P3 emitting light in a third color. Each sub-pixel may include a circuit unit and a light emitting unit. The circuit unit may at least include a pixel drive circuit, the pixel drive circuit is connected with a scan signal line, a data signal line, and a light emitting signal line, respectively, and the pixel drive circuit is configured to receive a data voltage transmitted by the data signal line and output a corresponding current to the light emitting device under control of the scan signal line and the light emitting signal line. The light emitting unit may at least include a light emitting device. The light emitting device is connected with a pixel drive circuit of a sub-pixel where the light emitting device is located. The light emitting device is configured to emit light with a corresponding brightness in response to a current output by the pixel drive circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of a rectangle, a rhombus, a pentagon, or a hexagon. Three sub-pixels may be arranged in a manner to stand side by side horizontally, in a manner to stand side by side vertically, in a Chinese word " 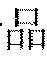 " or the like, which is not limited herein in the present disclosure.

In an exemplary implementation, a pixel unit may include four sub-pixels, and the four sub-pixels may be arranged in a manner to stand side by side horizontally, in a manner to stand side by side vertically, or in a manner of a square, which is not limited herein in the present disclosure.

FIG. 3 is a schematic diagram of a sectional structure of a display substrate, which illustrates a structure of three sub-pixels of the display substrate. As shown in FIG. 3, in a plane perpendicular to the display substrate, a display area of the display substrate may include a drive circuit layer 102 disposed on a base substrate 101, a light emitting structure layer 103 disposed on a side of the drive circuit layer 102 away from the base substrate 101, and an encapsulation structure layer 104 disposed on a side of the light emitting structure layer 103 away from the base substrate 101. In some possible implementations, the display substrate may include another film layer, such as a touch structure layer, which is not limited herein in the present disclosure.

In an exemplary implementation, the base substrate 101 may be a flexible base substrate, or may be a rigid base substrate. The drive circuit layer 102 may include multiple circuit units, a circuit unit may at least include a pixel drive circuit, and the pixel drive circuit may include multiple transistors and a storage capacitor. The light emitting structure layer 103 may include multiple light emitting units, a light emitting unit may at least include a light emitting device, and the light emitting device may include an anode, an organic emitting layer, and a cathode. The anode is connected to a pixel drive circuit. The organic emitting layer is connected to the anode. The cathode is connected to the organic emitting layer. The organic emitting layer emits light of a corresponding color under driving of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is arranged between the first encapsulation layer and the third encapsulation layer to form a laminated structure of inorganic material/organic material/inorganic material and ensure that external moisture cannot enter the light emitting structure layer 103.

In an exemplary implementation, the organic emitting layer may include an Emitting Layer (EML), and any one or more of the following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL).

An exemplary embodiment of the present disclosure provides a display substrate, including: an active layer, disposed on a side of a base substrate; a first gate, disposed on a first side of the active layer; a second gate, disposed on a second side of the active layer, the second gate being electrically connected with the active layer; and a third gate, disposed on the second side of the active layer, the third gate and the second gate being insulated from each other and the third gate being electrically connected with the first gate.

The first side and the second side are two opposite sides of the active layer in a direction perpendicular to the base substrate respectively, and an orthographic projection of the first gate on the base substrate, an orthographic projection of the second gate on the base substrate, and an orthographic projection of the third gate on the base substrate are all overlapped with an orthographic projection of the active layer on the base substrate.

In an exemplary implementation, a signal line provided on the base substrate are further included, an orthographic projection of the signal line on the base substrate is overlapped with each of the orthographic projection of the second gate on the base substrate and the orthographic projection of the third gate on the base substrate.

In an exemplary implementation, the orthographic projection of the second gate on the base substrate is not overlapped with the orthographic projection of the third gate on the base substrate, and there is a partition region provided between the orthographic projection of the second gate on the base substrate and the orthographic projection of the third gate on the base substrate.

In an exemplary implementation, an area of the orthographic projection of the second gate on the base substrate is greater than or equal to an area of the orthographic projection of the third gate on the base substrate.

In an exemplary implementation, an area of the orthographic projection of the second gate on the base substrate is less than or equal to an area of the orthographic projection of the third gate on the base substrate.

In an exemplary implementation, the second gate includes a conductive material with a high work function.

In an exemplary implementation, the third gate includes a conductive material with a low work function.

In the display substrate of an embodiment of the present disclosure, by connecting the second gate with a source end (S) of the active layer, and connecting the third gate with the first gate, the Bulk Accumulation effect may be realized, the sub-threshold swing amplitude (SS) of the transistor of the display substrate may be increased, the data range may be increased, and the starting current (Ion) of the transistor may not be reduced. For example, the switching ratio (ratio of the starting current to the closing current) of the transistor with the existing double-gate structure is 10⁸, and the switching ratio (ratio of the starting current to the closing current) of the transistor of the display substrate of an embodiment of the present disclosure may be greater than 10⁸.

Bulk Accumulation effect means that an accumulation layer of conductive electrons is formed at an interface between a top gate and a bottom gate, forming two channels, that is, a channel formed by the bottom gate and a channel formed by the top gate. Through double-channel driving, a potential of a channel layer may be controlled more effectively, because each gate only needs to increase the potential at half a depth of the channel layer, and compared with single-gate transistors, it needs to increase a potential at a gate insulation layer interface with an increase of the gate bias voltage. From an analysis of an energy band structure, conduction band states of the double-gate structure are quickly filled up due to a movement of the Fermi-level (EF) to guide band (EC), so that the conduction band states are turned on.

The display substrate in the present disclosure is illustrated with examples below through some exemplary embodiments.

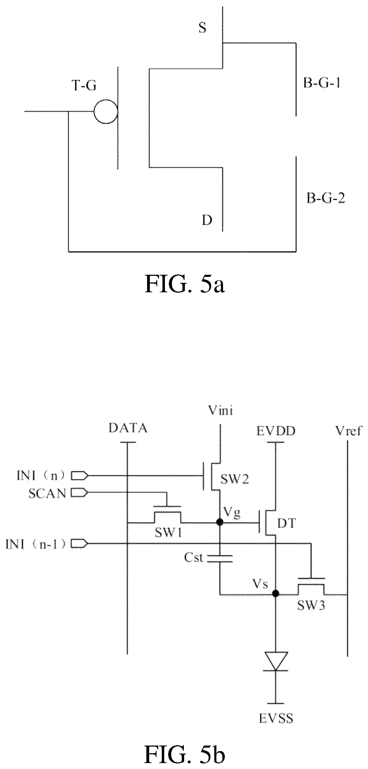

FIG. 5a is an equivalent circuit diagram of a transistor of a display substrate according to an exemplary embodiment of the present disclosure. In an exemplary implementation, the pixel drive circuit of the display substrate of this embodiment may be a 3T1C, 4T1C, 5T1C, 5T2C, 6T1C, 7T1C, 7T2C, 8T1C or 9T2C structure, where T is a transistor and C is a capacitor. As shown in FIG. 5a, the transistor of the pixel drive circuit of the display substrate of an embodiment of the present disclosure is a three-gate structure, and the transistor of an embodiment of the present disclosure may be a drive transistor and/or a switching transistor in the pixel drive circuit, preferably as a drive transistor. The transistor of an embodiment of the present disclosure may include an active layer, a first gate, a second gate, and a third gate. The first gate may be used as a top gate (T-G) of the transistor, the second gate may be used as a first bottom gate (B-G-1) of the transistor, the second gate may be connected to a source end (S) of the active layer, the third gate may be used as a second bottom gate (B-G-2) of the transistor, and the third gate may be connected to the first gate.

The operating timing of the pixel drive circuit will be explained below with the example that the pixel drive circuit of the display substrate of this embodiment is 4T1C.

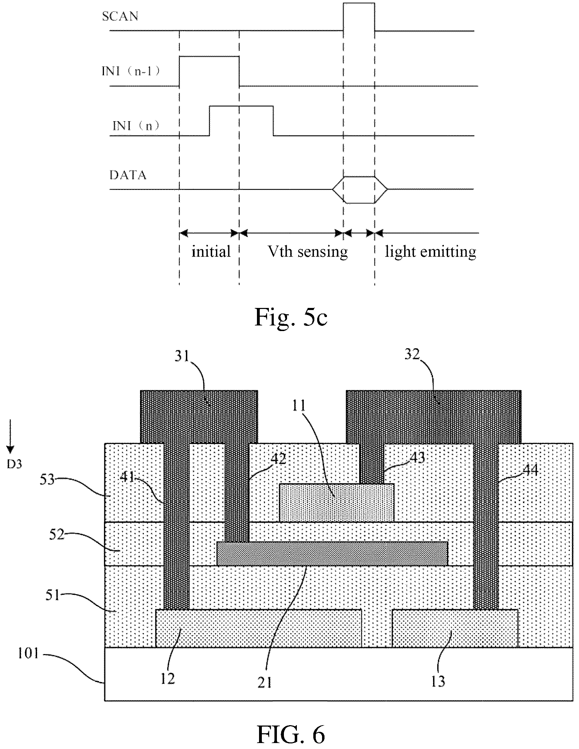

As shown in FIGS. 5b and 5c, the operating timing of the pixel drive circuit of the display substrate of this embodiment includes the following.

In an initialization period (initial), a SCAN signal SCAN(n) has an off-level to turn off a first switch TFT SW1, and an initialization signal INI(n) becomes to have an on-level to turn on a second switch TFT SW2 and a third switch TFT SW3, so that an initialization voltage Vini is applied to a gate node of a drive TFT DT, and a reference voltage Vref is applied to a source node of the drive TFT DT. The initialization period may be a horizontal period 1H.

A voltage corresponding to a difference between the initialization voltage Vini and the reference voltage Vref is charged to a storage capacitor Cst, so that the voltage between a gate node and a source node of the drive TFT DT becomes (Vini-Vref). The initialization voltage Vini is higher than the reference voltage Vref by an amount sufficient to turn the drive TFT DT on. For example, the initialization voltage Vini may be 4 V, and the reference voltage Vref may be 1 V.

At the front of a threshold voltage sensing period (vth sensing), the SCAN signal SCAN(n) holds an off-level to keep the first switch TFT SW1 off, and the initialization signal INI(n) holds an on-level to keep the second switch TFT SW2 on. As a result, the initialization voltage Vini is continuously applied to the gate node of the drive TFT DT, and the reference signal REF(n) becomes an off-level to float the source node of the drive TFT DT.

In the initialization period, the drive TFT DT is turned on by the voltage charged in the storage capacitor Cst. In the threshold voltage sensing period, the voltage of the source node of the drive TFT DT rises (source following) towards the voltage of the gate node due to a current flowing through the drive TFT DT. Thus, if the sensing period is long enough, the voltage of the source node of the drive TFT DT rises until a difference between the initialization voltage applied to the gate node of the drive TFT DT and the voltage of the source node corresponds to the threshold voltage Vth of the drive TFT DT.

At the end of the threshold voltage sensing period (Vth sensing), as shown in FIG. 5C, the SCAN signal SCAN(n) holds an off-level to keep the first switch TFT SW1 off, the initialization signal INI(n) becomes an off-level to turn off the second switch TFT SW2, which floats the gate node of the drive TFT DT, and the reference signal REF(n) holds an off-level to float the source node of the drive TFT DT.

The drive TFT DT is maintained in the turned on state by the voltage charged in the storage capacitor Cst, so that the voltage of the source node of the drive TFT DT rises due to the current flowing through the drive TFT DT, and the voltage of the gate node of the drive TFT DT rises due to the storage capacitor Cst connected to the source node, but an amplitude of the rise of the voltage of the gate node of the drive TFT DT is less than an amplitude of the rise of the voltage of the source node. Therefore, if time goes on, a voltage corresponding to the threshold voltage of the drive TFT DT may be charged to the storage capacitor Cst.

In a data writing and mobility sensing period (writing and µ sensing), the SCAN signal SCAN(n) becomes an on-level that turns the first switch TFT SW1 on, so that a data voltage supplied to a data line is applied to the gate node of the drive TFT DT, and the initialization signal INI(n) remains at the off-level.

The voltage of the gate node of the drive TFT DT rapidly rises to the data voltage, a current corresponding to a voltage difference between the gate node and the source node flows through the drive TFT DT, and the voltage of the source node of the drive TFT DT rises towards the data voltage applied to the gate node of the drive TFT DT. Thus, the voltage difference between the gate node and the source node of the drive TFT DT is programmed to a desired gray scale.

That is, when a current flowing through the drive TFT DT is expressed as I=K*(Vgs-Vth)2, where K is a constant related to an electron mobility and proportional to the electron mobility. In the case where the electron mobility of the drive TFT DT is high (K has a great value), the voltage of the source node of the drive TFT DT rises rapidly and Vgs decreases relatively quickly. In the case where the electron mobility of the drive TFT DT is small (K has a small value), the voltage of the source node of the drive TFT DT rises slowly and Vgs decreases relatively slowly, so that the current flowing through the drive TFT DT becomes independent of the electron mobility and may compensate for the electron mobility.

In a light emitting period (light emitting), the SCAN signal SCAN(n) becomes an off-level to turn off the first switch TFT SW1, and the initialization signal INI(n) and the reference signal REF(n) remain at the off-level.

A current corresponding to a programmed potential difference between the gate node and the source node of the drive TFT DT during the data writing period (i.e., a potential difference programmed in the storage capacitor Cst) flows. Therefore, the voltage of the source node of the drive TFT DT rises, the voltage of the gate node also rises, while maintaining the programmed potential difference, and the voltage of the source node becomes higher than a voltage for driving a light emitting diode, which causes the light emitting diode to emit light.

FIG. 6 is a schematic diagram of a sectional structure of a display substrate according to an exemplary embodiment of the present disclosure, and illustrates a structure of one transistor of a display substrate. In an exemplary implementation, as shown in FIG. 6, in a plane perpendicular to the display substrate, the display substrate of an exemplary embodiment of the present disclosure includes a base substrate 101, a second gate 12 and a third gate 13 provided on the base substrate 101, a first insulation layer 51 provided on a side of the second gate 12 and the third gate 13 away from the base substrate 101, an active layer 21 provided on a side of the first insulation layer 51 away from the base substrate 101, a second insulation layer 52 provided on a side of the active layer 21 away from the base substrate 101, a first gate 11 provided on a side of the second insulation layer 52 away from the base substrate 101, a third insulation layer 53 provided on a side of the first gate 11 away from the base substrate 101, and a first connection electrode 31 and a second connection electrode 32 provided on a side of the third insulation layer 53 away from the base substrate 101. The first gate 11, the second gate 12, the third gate 13, and the active layer 21 form a transistor of the display substrate. The first gate 11 may serve as a top gate of the transistor, the second gate 12 may serve as a first bottom gate of the transistor, and the second gate 12 is connected to a source end of the active layer 21. The third gate 13 may serve as a second bottom gate of the transistor, and the third gate 13 is connected to the first gate 11. The active layer 21 includes a source end and a drain end, the source end and the drain end are located at two opposite ends of the active layer 21, the source end of the active layer 21 may be used for connecting with the source electrode, and the drain end of the active layer 21 may be used for connecting with the drain electrode.

In an exemplary implementation, an orthographic projection of the first gate 11 on the base substrate 101, an orthographic projection of the second gate 12 on the base substrate 101, and an orthographic projection of the third gate 13 on the base substrate 101 are all overlapped with an orthographic projection of the active layer 21 on the base substrate 101. By way of example, the orthographic projection of the first gate 11 on the base substrate 101 is located in the orthographic projection of the active layer 21 on the base substrate 101, and at least portions of the orthographic projection of the second gate 12 on the base substrate 101 and the orthographic projection of the third gate 13 on the base substrate 101 are both overlapped with the orthographic projection of the active layer 21 on the base substrate 101.

In an exemplary implementation, the second gate 12 and the third gate 13 may be located on a same film layer, and an orthographic projection of the second gate 12 on the base substrate is not overlapped with an orthographic projection of third gate 13 on the base substrate. In some embodiments, the second gate and the third gate may be located on different film layers, for example, the first gate may be located on a side of the second gate away from or close to the base substrate.

In an exemplary implementation, the second gate 12 and the third gate 13 are located on a side of the active layer 21 close to the base substrate, and the first gate 11 is located on a side of the active layer 21 away from the base substrate. In some embodiments, the second gate and the third gate may be located on a side of the active layer away from the base substrate, and the first gate may be located on a side of the active layer close to the base substrate.

In an exemplary implementation, the second gate 12 and the third gate 13 may be made of conductive materials with different work functions. By way of example, the second gate 12 may be made of a conductive material with a high work function, for example, a metal with a high work function, which may include metal molybdenum. The third gate 13 may be made of a conductive material with a low work function, for example, a metal with a low work function, which may include at least one of aluminum, silver, and zinc.

In the display substrate of an embodiment of the present disclosure, the third gate is made of a conductive material with a low work function, which may greatly reduce a contact resistance between the second connection electrode and the third gate, improve a control ability of the third gate, and increase the starting current of the transistor under the premise of increasing the sub-threshold swing amplitude (SS).

In some embodiments, the second gate and the third gate may employ a conductive material with a same work function. For example, the second gate and the third gate may be prepared from a same conductive film layer, including a same conductive material, thereby simplifying the process, which will not be described herein in detail in an embodiment of the present disclosure.

In an exemplary implementation, the display substrate of an exemplary embodiment of the present disclosure further includes a first via 41, a second via 42, a third via 43, and a fourth via 44. The first via 41, the second via 42, the third via 43, and the fourth via 44 all extend in a direction perpendicular to the base substrate 101, and an orthographic projection of the first via 41 on the base substrate 101, an orthographic projection of the second via 42 on the base substrate 101, an orthographic projection of the third via 43 on the base substrate 101, and an orthographic projection of the fourth via 44 on the base substrate 101 are not all overlapped with each other. The first via 41 runs through the third insulation layer 53, the second insulation layer 52, and the first insulation layer 51 sequentially from a surface of the third insulation layer 53 away from the base substrate, and extends to the second gate 12, exposing at least a portion of the second gate 12, and the first connection electrode 31 is connected to the exposed second gate 12 through the first via 41. The second via 42 runs through the third insulation layer 53 and the second insulation layer 52 sequentially from the surface of the third insulation layer 53 away from the base substrate, and extends to the source end of the active layer 21, exposing at least a portion of the source end of the active layer 21, and the first connection electrode 31 is connected to the source end of the exposed active layer 21 through the second via 42, so that the first connection electrode 31 connects the second gate 12 with the source end of the active layer 21. The third via 43 runs through the third insulation layer 53 from the surface of the third insulation layer 53 away from the base substrate, and extends to the first gate 11, exposing at least a portion of the first gate 11, and the second connection electrode 32 is connected to the exposed first gate 11 through the third via 43. The fourth via 43 runs through the third insulation layer 53, the second insulation layer 52, and the first insulation layer 51 sequentially from the surface of the third insulation layer 53 away from the base substrate, and extends to the third gate 13, exposing at least a portion of the third gate 13, and the second connection electrode 32 is connected to the exposed third gate 13 through the fourth via 44, so that the second connection electrode 32 connects the first gate 11 to the third gate 13.

In the display substrate of an embodiment of the present disclosure, by connecting the second gate to the source end (S) of the active layer, and connecting the third gate to the first gate, the Bulk Accumulation effect may be realized, the sub-threshold swing amplitude (SS) of the transistor of the display substrate may be increased, the data range may be increased, and the starting current (Ion) of the transistor may not be reduced.

In an exemplary implementation, the first insulation layer 51, the second insulation layer 52, and the third insulation layer 53 may employ an inorganic material, such as an oxysilicon compound or a nitrosilicon compound. The first insulation layer 51 may be referred to as a first gate insulation layer, and isolates the second gate 12 and the third gate 13 from the active layer 21. The second insulation layer 52 may be referred to as a second gate insulation layer, and isolates the first gate 11 from the active layer 21.

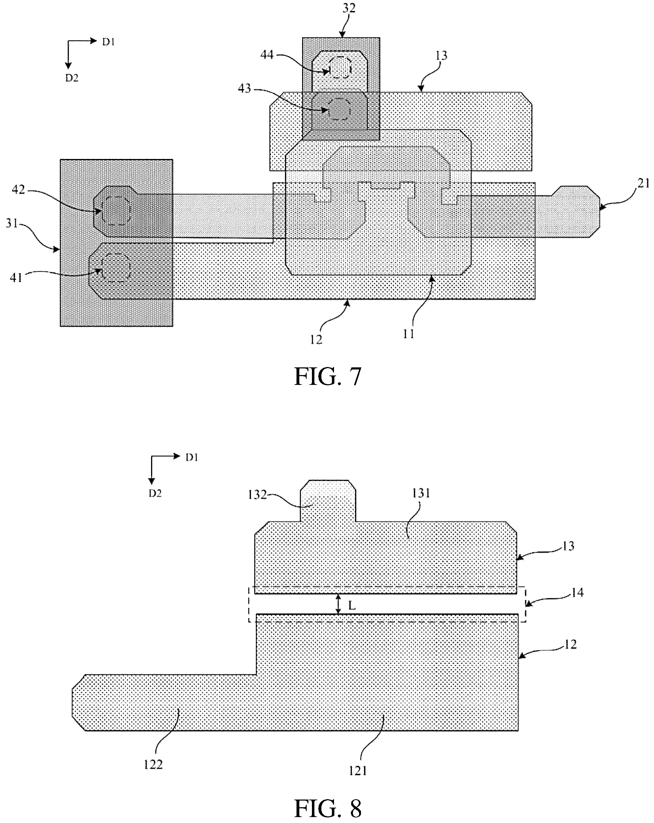

FIG. 7 is a schematic diagram of a planar structure of a display substrate according to an exemplary embodiment of the present disclosure, and illustrates a structure of one transistor of a display substrate. In an exemplary implementation, as shown in FIG. 7, in a plane parallel to the display substrate, the display substrate of an exemplary embodiment of the present disclosure includes a second gate 12 and a third gate 13 provided on the base substrate, an active layer 21 provided on a side of the second gate 12 and the third gate 13 away from the base substrate, a first gate 11 provided on a side of the active layer 21 away from the base substrate 101, and a first connection electrode 31 and a second connection electrode 32 provided on a side of the first gate 11 away from the base substrate 101.

In an exemplary implementation, the display substrate of an exemplary embodiment of the present disclosure further includes a first via 41, a second via 42, a third via 43, and a fourth via 44. The first via 41, the second via 42, the third via 43, and the fourth via 44 all extend in a direction perpendicular to the base substrate 101, and an orthographic projection of the first via 41 on the base substrate 101, an orthographic projection of the second via 42 on the base substrate 101, an orthographic projection of the third via 43 on the base substrate 101, and an orthographic projection of the fourth via 44 on the base substrate 101 are not all overlapped with each other. The first connection electrode 31 is connected with the second gate 12 through the first via 41, and the first connection electrode 31 is connected with the source end of the active layer 21 through the second via 42, so that the first connection electrode 31 connects the second gate 12 with the source end of the active layer 21. The second connection electrode 32 is connected with the third gate 13 through the third via 43, and the second connection electrode 32 is connected with the first gate 11 through the fourth via 44, so that the second connection electrode 32 connects the first gate 11 with the third gate 13.

Exemplary description is made below through a manufacturing process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation, the manufacturing process of the display substrate according to this embodiment may include the following acts.

(11) Forming a pattern of a second gate and a pattern of a third gate. In an exemplary implementation, forming the pattern of the second gate and the pattern of the third gate may include depositing a buffer layer on a base substrate at a temperature of 380°C by a plasma enhanced chemical vapor deposition (PECVD) process; subsequently, depositing a metal thin film with a high work function on the buffer layer by a first sputtering process, and patterning the metal thin film with a high work function by a patterning process to form the pattern of the second gate 12 provided on the buffer layer; subsequently, depositing a metal thin film with a low work function on the buffer layer by a second sputtering process, and patterning the metal thin film with a low work function by a patterning process to form the pattern of the third gate 13 provided on the buffer layer; finally, depositing a first insulation thin film on the second gate 12 and the third gate 13 at a temperature of 380°C by a plasma enhanced chemical vapor deposition (PECVD) process to form a first insulation layer covering the second gate 12 and the third gate 13, as shown in FIG. 8. The buffer layer may be made of silicon oxide, and a thickness of the buffer layer may be 50 nanometers to 100 nanometers; the first insulation layer may be made of silicon oxide, and a thickness of the first insulation layer may be 100 nanometers to 300 nanometers; the second gate 12 may be made of molybdenum metal; and the third gate 13 may be made of at least one of aluminum, silver, and zinc.

In some embodiments, a pattern of a third gate may be formed first and then a pattern of the second gate may be formed, which will not be described herein in embodiments of the present disclosure.

In an exemplary implementation, the second gate 12 may be located on a side of the third gate 13 in a second direction D2 and insulated from the third gate 13. The second gate 12 includes a second electrode part 121 and a second lead part 122 connected integrally. A shape of the second electrode part 121 may be rectangular and at least one corner of the second electrode part 121 may be chamfered. The second lead part 122 may be in a shape of a line, a first end of the second lead part 122 is connected with an edge of the second electrode part 121 in an opposite direction of a first direction D1, a second end of the second lead part 122 extends in the opposite direction of the first direction D1, and the second lead part 122 may be connected to the first connection electrode through a first via. The first direction D1 and the second direction D2 are both parallel to a plane of the base substrate, and the first direction D1 intersects with the second direction D2, for example, the first direction D1 is perpendicular to the second direction D2.

In some implementations, a shape of an orthographic projection of the second electrode part on the base substrate may include at least one of a triangle, a rhombus, a trapezoid, a circle, an oval, a pentagon, and a hexagon.

In an exemplary implementation, the third gate 13 may be located on a side of the second gate 12 in an opposite direction of the second direction D2 and insulated from the second gate 12. The third gate 13 includes a third electrode part 131 and a third lead part 132 connected integrally. A shape of the third electrode part 131 may be rectangular, and at least one corner of the third electrode part 131 may be chamfered. For example, a corner of the third electrode part 131 on a side away from the second gate 12 may be chamfered. The third lead part 132 may be in a shape of a line, a first end of the third lead part 132 is connected with an edge of the third electrode part 131 in the opposite direction of the second direction D2, a second end of the third lead part 132 extends in the opposite direction of the second direction D2, and the third lead part 132 may be connected to the second connection electrode through a fourth via.

In some implementations, a shape of an orthographic projection of the third electrode part on the base substrate may include at least one of a triangle, a rhombus, a trapezoid, a circle, an oval, a pentagon, and a hexagon.

In an exemplary implementation, an area of the orthographic projection of the second gate 12 on the base substrate is greater than or equal to an area of the orthographic projection of the third gate 13 on the base substrate. By way of example, an area of an orthographic projection of the second electrode part 121 of the second gate 12 on the base substrate is greater than or equal to an area of an orthographic projection of the third electrode part 131 of the third gate 13 on the base substrate.

In an exemplary implementation, a ratio of the area of the orthographic projection of the second electrode part 121 of the second gate 12 on the base substrate to the area of the orthographic projection of the third electrode part 131 of the third gate 13 on the base substrate is less than or equal to 2 but greater than or equal to 1. By way of example, the ratio of the area of the orthographic projection of the second electrode part 121 of the second gate 12 on the base substrate to the area of the orthographic projection of the third electrode part 131 of the third gate 13 on the base substrate is less than or equal to 1.8 but greater than or equal to 1.5.

The display substrate of an embodiment of the present disclosure regulates a compatibility level of the sub-threshold swing amplitude (SS) of the transistor and the starting current (Ion) of the transistor by regulating a ratio of an area of the second gate 12 to an area of the third gate 13.

In some embodiments, the area of the orthographic projection of the second electrode part of the second gate on the base substrate may be less than the area of the orthographic projection of the third electrode part of the third gate on the base substrate.

In an exemplary implementation, a partition region 14 is provided between the second gate 12 and the third gate 13, and the partition region 14 may be filled with a first insulation layer to be formed subsequently. A shape of the partition region 14 is a line shape, and the partition region 14 extends in the first direction D1, separating the second gate 12 from the third gate 13. Two opposite edges of the partition region 14 in the second direction D2 are an edge of the second gate 12 close to the third gate 13 and an edge of the third gate 13 close to the second gate 12, respectively.

In some embodiments, the shape of the partition region may be a serpentine shape.

In an exemplary implementation, a vertical distance L of the partition region 14 in the second direction D2 is greater than or equal to 0.5 micron and less than or equal to 2 microns, and for example, the distance L may be greater than or equal to 1 micron and less than or equal to 1.5 microns. The vertical distance L is a vertical distance in the second direction D2 from an edge of the second gate 12 close to the third gate 13 to an edge of the third gate 13 close to the second gate 12.

In some embodiments, the shape of the partition region may be a bending line shape, which will not be described herein in detail in embodiments of the present disclosure.

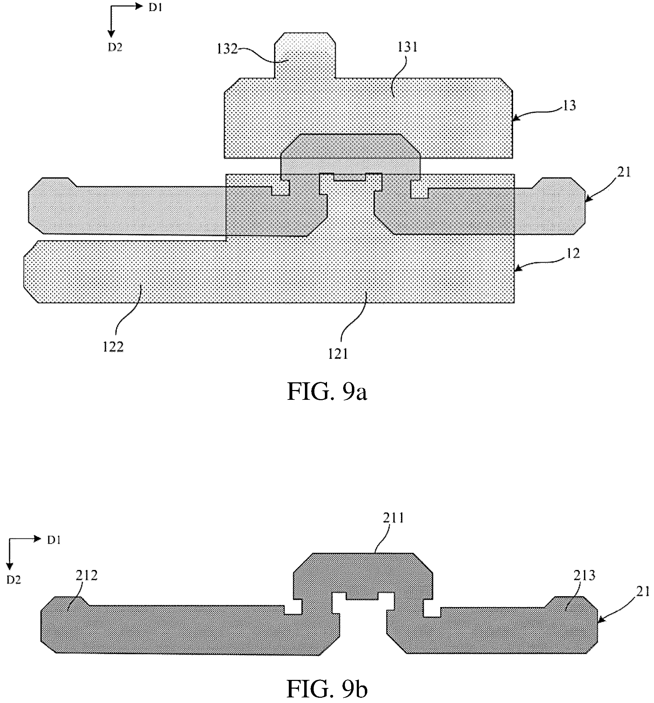

(12) Forming a pattern of an active layer. In an exemplary implementation, forming the pattern of the active layer may include: depositing a semiconductor thin film on a first insulation layer at room temperature by a sputtering process on a base substrate on which the aforementioned patterns are formed, and patterning the semiconductor thin film by a patterning process to form the pattern of the active layer 21 disposed on the first insulation layer; subsequently, depositing a second insulation thin film on the active layer 21 by a plasma enhanced chemical vapor deposition (PECVD) process at a temperature of 380°C to form a second insulation layer covering the active layer 21, as shown in FIGS. 9a and 9b. FIG. 9b is a schematic diagram of the active layer in FIG. 9a.

In an exemplary implementation, the active layer 21 includes a channel region 211 and a source end 212 and a drain end 213 at two opposite ends of the channel region 211 in the first direction D1. A shape of the channel region 211 is an inverted U shape, the channel region 211 is raised in the opposite direction of the second direction D2, and an orthographic projection of the channel region 211 on the base substrate is overlapped with the orthographic projection of the second gate 12 on the base substrate and the orthographic projection of the third gate 13 on the base substrate, respectively. The source end 212 is connected with one end of the channel region 211 in the opposite direction of the first direction D1, and a shape of the source end 212 is a block. The source end 212 may be connected with the first connection electrode through a second via. The drain end 213 is connected with one end of the channel region 211 in the first direction D1, a shape of the drain end 213 is a block, and the drain end 213 may be connected with the source end 212 through the channel region 211. A thickness of the active layer 21 may be from 15 nanometers to 25 nanometers.

In an exemplary implementation, an orthographic projection of the source end 212 of the active layer 21 on the base substrate is not overlapped with an orthographic projection of the second lead part 122 of the second gate 12 on the base substrate.

In an exemplary implementation, a material of the channel region 211 of the active layer 21 may include poly-crystalline silicon or metal oxide. The metal oxides may include Indium Gallium Zinc Oxide (IGZO), Indium Gallium Oxide (IGO), and the like. By way of example, a material of the channel region 211 may be indium gallium oxide, and a weight percentage of indium oxide to gallium oxide in the channel region 211 is 1: 1.

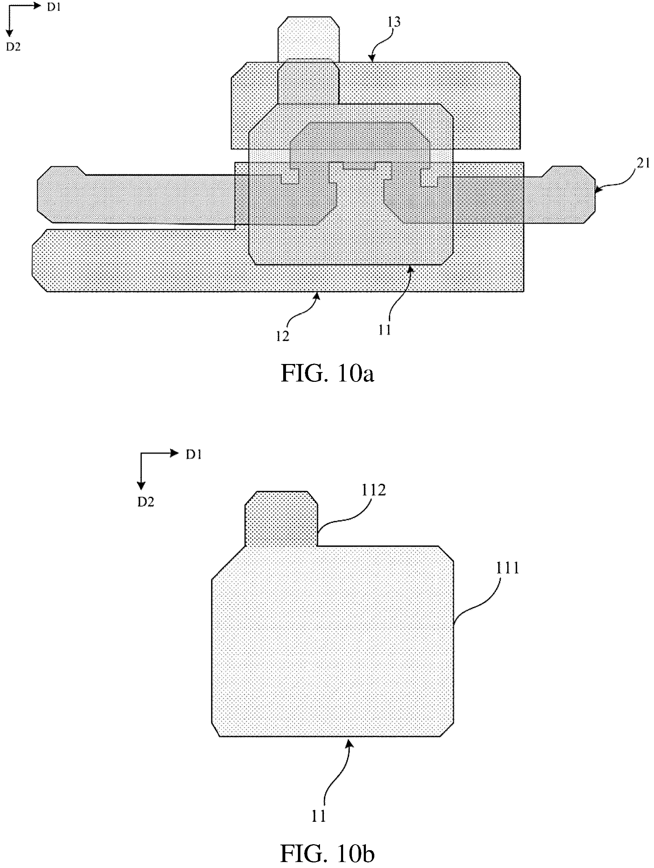

(13) Forming a pattern of a first gate. In an exemplary implementation, forming the pattern of the first gate may include: depositing a first conductive thin film on the second insulation layer by a sputtering process on the base substrate on which the aforementioned patterns are formed, and patterning the first conductive thin film by a patterning process to form the pattern of the first gate 11 disposed on the second insulation layer; subsequently, depositing a third insulation thin film on the first gate 11 by a plasma enhanced chemical vapor deposition (PECVD) process at a temperature of 380°C to form a third insulation layer covering the first gate 11, as shown in FIGS. 10a and 10b. FIG. 10b is a schematic diagram of the first gate in FIG. 10a.

In an exemplary implementation, an orthographic projection of the first gate 11 on the base substrate is overlapped with an orthographic projection of the active layer 21 on the base substrate, and the orthographic projection of the first gate 11 on the base substrate is overlapped with each of the orthographic projection of the second gate 12 on the base substrate and the orthographic projection of the third gate 13 on the base substrate. The first gate 11 includes a first electrode part 111 and a first lead part 112 connected integrally. A shape of the first electrode part 111 may be rectangular and an orthographic projection of the first electrode part 111 on the base substrate is overlapped with an orthographic projection of the channel region of the active layer 21 on the base substrate. At least one corner of the first electrode part 111 may be chamfered, and, for example, all four corners of the first electrode part 111 are chamfered. A shape of the first lead part 112 may be a line shape, a first end of the first lead part 112 is connected with an edge of the first electrode part 111 in the opposite direction of the second direction D2, and a second end of the first lead part 112 extends in the opposite direction of the second direction D2. An orthographic projection of at least a portion of the first lead part 112 on the base substrate is not overlapped with an orthographic projection of the third lead part of the third gate 13 on the base substrate, and the first lead part 112 may be connected with the second connection electrode through a third via.

In some implementations, a shape of an orthographic projection of the first electrode part on the base substrate may include at least one of a triangle, a rhombus, a trapezoid, a circle, an oval, a pentagon, and a hexagon.

(14) Forming a pattern of a first connection electrode and a pattern of a second connection electrode. In an exemplary implementation, forming the pattern of the first connection electrode and the pattern of the second connection electrode may include first forming a first via 41, a second via 42, a third via 43, and a fourth via 44 on the base substrate on which the aforementioned patterns are formed. The first via 41, the second via 42, the third via 43, and the fourth via 44 all extend in a direction perpendicular to the base substrate 101, and an orthographic projection of the first via 41 on the base substrate 101, an orthographic projection of the second via 42 on the base substrate 101, an orthographic projection of the third via 43 on the base substrate 101, and an orthographic projection of the fourth via 44 on the base substrate 101 are not all overlapped with each other. The first via 41 exposes at least a portion of the second gate 12, the second via 42 exposes at least a portion of the source end of the active layer 21, the third via 43 exposes at least a portion of the third gate 13, and the fourth via 44 exposes at least a portion of the first gate 11. Forming the pattern of the first connection electrode and the pattern of the second connection electrode may further include subsequently, depositing a second conductive thin film on the third insulation layer by a sputtering process, and patterning the second conductive thin film by a patterning process to form the pattern of the first connection electrode 31 and the pattern of the second connection electrode 32 provided on the third insulation layer. The first connection electrode 31 is connected to the second gate 12 through the first via 41, and is connected to the source end of the active layer 21 through the second via 42. The second connection electrode 32 is connected to the first gate 11 through the third via 43, and connected to the third gate 13 through the fourth via 44, as shown in FIG. 7.

In an exemplary implementation, both the first connection electrode 31 and the second connection electrode 32 may have a multi-film layer structure. For example, both the first connection electrode 31 and the second connection electrode 32 may include a first conductive layer, a second conductive layer, and a third conductive layer stacked in a thickness direction of the base substrate. Both the first conductive layer and the third conductive layer may be made of titanium metal, and the second conductive layer may be made of aluminum metal.

In an exemplary implementation, shapes of the first connection electrode 31 and the second connection electrode 32 may both be rectangular. By way of example, a length of the first connection electrode 31 and the second connection electrode 32 may be 2 microns to 4 microns, and a width of the first connection electrode 31 and the second connection electrode 32 may be 2 microns to 4 microns.

In an exemplary implementation, the shapes of the first via 41, the second via 42, the third via 43, and the fourth via 44 may each include at least one of a triangle, a rectangle, a rhombus, a trapezoid, a circle, an oval, a pentagon, or a hexagon.

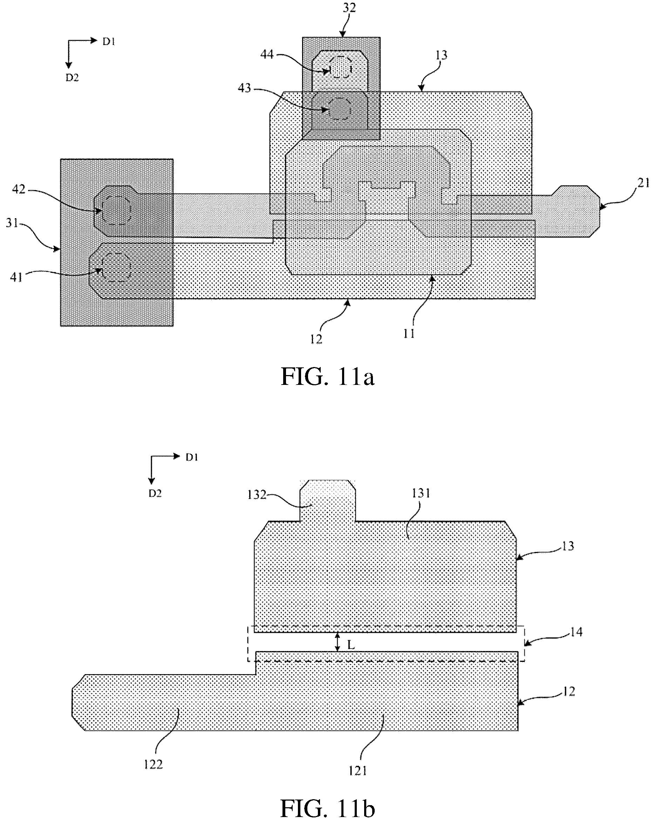

FIGS. 11a and 11b are schematic planar diagrams of another display substrate according to the present disclosure, and FIG. 11b is a schematic diagram of a second gate and a third gate in FIG. 11a. As shown in FIGS. 11a and 11b, a structure of the display substrate of this exemplary embodiment is substantially the same as a structure of the display substrate of the embodiment shown in FIG. 7, except that the area of the orthographic projection of the second gate 12 of the display substrate of this exemplary embodiment on the base substrate is less than or equal to the area of the orthographic projection of the third gate 13 on the base substrate. By way of example, the area of the orthographic projection of the second electrode part of the second gate 12 on the base substrate is less than or equal to the area of the orthographic projection of the third electrode part of the third gate 13 on the base substrate. In an exemplary implementation, the ratio of the area of the orthographic projection of the second electrode part of the second gate 12 on the base substrate to the area of the orthographic projection of the third electrode part of the third gate 13 on the base substrate is less than or equal to 1 and greater than or equal to 0.1. By way of example, the ratio of the area of the orthographic projection of the second electrode part of the second gate 12 on the base substrate to the area of the orthographic projection of the third electrode part of the third gate 13 on the base substrate is less than or equal to 0.8 and greater than or equal to 0.5.

The display substrate of an embodiment of the present disclosure regulates a compatibility level of the sub-threshold swing amplitude (SS) of the transistor and the starting current (Ion) of the transistor by regulating a ratio of an area of the second gate 12 to an area of the third gate 13.

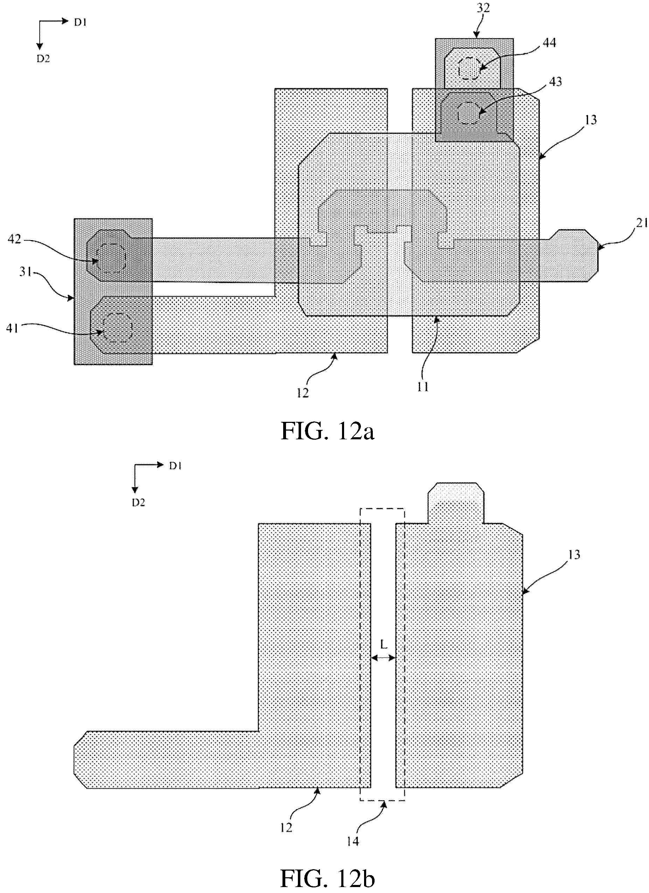

FIGS. 12a and 12b are schematic planar diagrams of another display substrate according to the present disclosure, and FIG. 12b is a schematic diagram of a second gate and a third gate in FIG. 12a. As shown in FIGS. 12a and 12b, a structure of the display substrate of this exemplary embodiment is substantially the same as a structure of the display substrate of the embodiment shown in FIG. 7, except that the second gate 12 of the display substrate of this exemplary embodiment is located on a side of the third gate 13 in the opposite direction of the first direction D1. A shape of the partition region 14 is a line shape, and the partition region 14 extends in the second direction D2, separating the second gate 12 from the third gate 13. Two opposite edges of the partition region 14 in the first direction D1 are an edge of the second gate 12 close to the third gate 13, and an edge of the third gate 13 close to the second gate 12, respectively.

In an exemplary implementation, a vertical distance L of the partition region 14 in the first direction D1 is greater than or equal to 0.5 micron and less than or equal to 2 microns, and for example, the distance L may be greater than or equal to 1 micron and less than or equal to 1.5 microns.

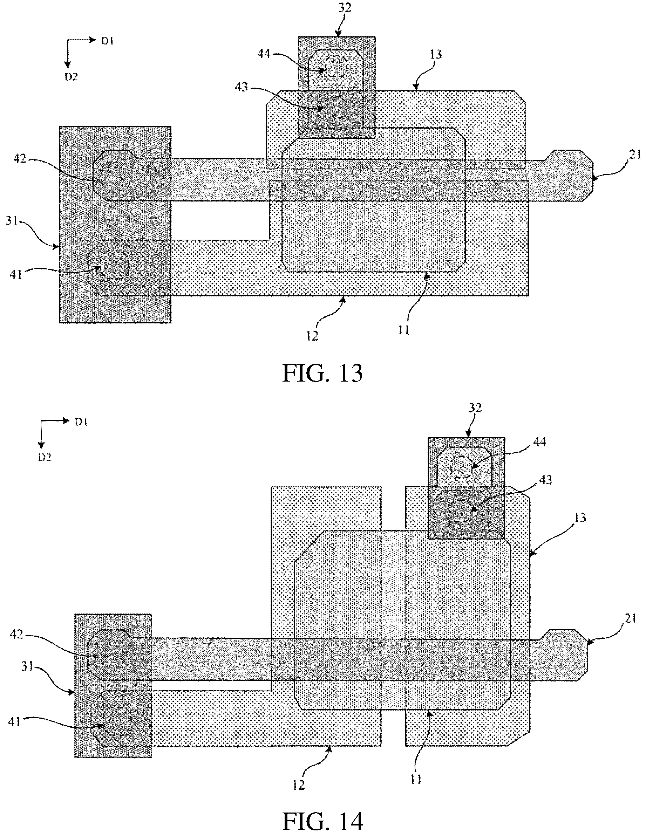

FIG. 13 is a schematic planar diagram of another display substrate according to the present disclosure. As shown in FIG. 13, a structure of the display substrate of this exemplary embodiment is substantially the same as a structure of the display substrate of the embodiment shown in FIG. 7, except that a shape of the channel region of the active layer 21 of the display substrate of this exemplary embodiment is a straight line shape. The channel region of the active layer 21 extends in the first direction D1, and an orthographic projection of the channel region of the active layer 21 on the base substrate is overlapped with each of the orthographic projection of the first gate 11 on the base substrate, the orthographic projection of the second gate 12 on the base substrate, and the orthographic projection of the third gate 13 on the base substrate.

FIG. 14 is a schematic planar diagram of another display substrate according to the present disclosure. As shown in FIG. 14, a structure of the display substrate of this exemplary embodiment is substantially the same as a structure of the display substrate of the embodiment shown in FIG. 12a, except that a shape of the channel region of the active layer 21 of the display substrate of this exemplary embodiment is a straight line shape. The channel region of the active layer 21 extends in the first direction D1, and an orthographic projection of the channel region of the active layer 21 on the base substrate is overlapped with each of the orthographic projection of the first gate 11 on the base substrate, the orthographic projection of the second gate 12 on the base substrate, and the orthographic projection of the third gate 13 on the base substrate.

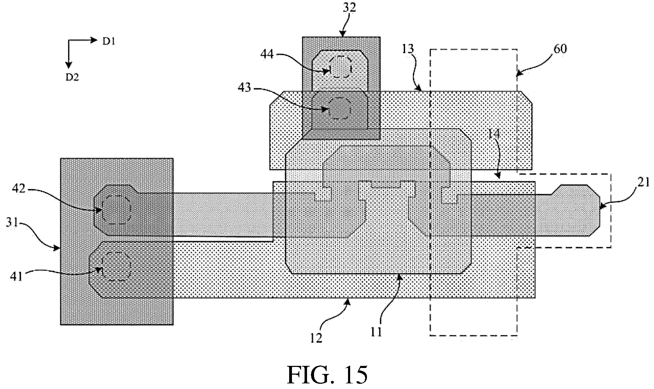

FIG. 15 is a schematic planar diagram of another display substrate according to the present disclosure. As shown in FIG. 15, a structure of the display substrate of this exemplary embodiment is substantially the same as a structure of the display substrate of the embodiment shown in FIG. 7, except that the display substrate of this exemplary embodiment further includes a signal line 60. The signal line 60 may be located on a side of the first gate 11 away from the base substrate, and a shape of the main structure of the signal line 60 may be a line shape extending in the second direction D2. An orthographic projection of the signal line 60 on the base substrate is overlapped with an orthographic projection of the partition region 14 on the base substrate, and the orthographic projection of the signal line 60 on the base substrate is overlapped with each of the orthographic projection of the second gate 12 on the base substrate and the orthographic projection of the third gate 13 on the base substrate. FIG. 15 illustrates a region where only a portion of the signal line 60 is located, and a shape of the signal line 60 may be a line shape extending in the second direction D2.

In an exemplary implementation, the signal line includes at least one of an initialization signal line, a reference voltage signal line, and a power supply signal line.

In the display substrate of an embodiment of the present disclosure, an orthographic projection of the signal line 60 on the base substrate is overlapped with each of the orthographic projection of the second gate 12 on the base substrate and the orthographic projection of the third gate 13 on the base substrate, and a coupling capacitance may be formed with the second gate 12 and the third gate 13 through the signal line 60, so that a compatibility level of the sub-threshold swing amplitude (SS) of the transistor and the starting current (Ion) of the transistor may be regulated.

The present disclosure further provides a manufacturing method for a display substrate, which includes: forming a second gate and a third gate on a base substrate; forming an active layer on a side of the second gate and the third gate away from the base substrate; forming a first gate on a side of the active layer away from the base substrate, an orthographic projection of the first gate on the base substrate, an orthographic projection of the second gate on the base substrate, and an orthographic projection of the third gate on the base substrate being all overlapped with an orthographic projection of the active layer on the base substrate; and electrically connecting the second gate to the active layer and electrically connecting the third gate to the first gate.

The present disclosure further provides a display apparatus which includes the aforementioned display substrate. The display apparatus may be any product or component with a display function, such as a mobile phone, a tablet computer, a television, a display, a laptop computer, a digital photo frame, or a navigator, which is not limited in the embodiments of the present invention.

Although implementations disclosed in the present disclosure are described as above, the described contents are only implementations which are used for facilitating understanding of the present disclosure, but are not intended to limit the present invention. Any skilled person in the art to which the present disclosure pertains may make any modification and variation in a form and details of implementation without departing from the spirit and scope of the present disclosure. However, the patent protection scope of the present invention should be subject to the scope defined in the appended claims.

## Claims

1. A display substrate, comprising:
an active layer, provided on a side of a base substrate;
a first gate, provided on a first side of the active layer;
a second gate, provided on a second side of the active layer, wherein the second gate is electrically connected with the active layer; and
a third gate, provided on the second side of the active layer, wherein the third gate and the second gate are insulated from each other, and the third gate is electrically connected with the first gate;
wherein the first side and the second side are two opposite sides of the active layer in a direction perpendicular to the base substrate respectively, and an orthographic projection of the first gate on the base substrate, an orthographic projection of the second gate on the base substrate, and an orthographic projection of the third gate on the base substrate are all overlapped with an orthographic projection of the active layer on the base substrate.

2. The display substrate according to claim 1, wherein the orthographic projection of the second gate on the base substrate is not overlapped with the orthographic projection of the third gate on the base substrate, a partition region is provided between the orthographic projection of the second gate on the base substrate and the orthographic projection of the third gate on the base substrate, and the partition region is filled with an insulation material.

3. The display substrate according to claim 2, wherein the second gate is located on a side of the third gate in a second direction, and a shape of the partition region is a line shape extending in a first direction; or, the second gate is located on a side of the third gate in the first direction, a shape of the partition region is a line shape extending in the second direction, and the first direction intersects with the second direction.

4. The display substrate according to claim 3, wherein in a plane parallel to the display substrate, a vertical distance of the partition region in the second direction is greater than or equal to 0.5 micron and less than or equal to 2 microns.

5. The display substrate according to claim 2, wherein the second gate is located on a side of the third gate in a first direction, a shape of the partition region is a line shape extending in a second direction, and the first direction intersects with the second direction.

6. The display substrate according to claim 5, wherein in a plane parallel to the display substrate, a vertical distance of the partition region in the first direction is greater than or equal to 0.5 micron and less than or equal to 2 microns.

7. The display substrate according to claim 2, wherein the partition region is in a bending line shape; or, the partition region is in a serpentine shape.

8. The display substrate according to any one of claims 1 to 7, further comprising a signal line provided on the base substrate, wherein an orthographic projection of the signal line on the base substrate is overlapped with each of the orthographic projection of the second gate on the base substrate and the orthographic projection of the third gate on the base substrate, and the signal line comprises at least one of an initialization signal line, a reference voltage signal line, and a power supply signal line.

9. The display substrate according to any one of claims 1 to 7, wherein an area of the orthographic projection of the second gate on the base substrate is greater than or equal to an area of the orthographic projection of the third gate on the base substrate.

10. The display substrate according to claim 9, wherein a ratio of the area of the orthographic projection of the second gate on the base substrate to the area of the orthographic projection of the third gate on the base substrate is less than or equal to 2 and greater than or equal to 1.

11. The display substrate according to any one of claims 1 to 7, wherein an area of the orthographic projection of the second gate on the base substrate is less than or equal to an area of the orthographic projection of the third gate on the base substrate.

12. The display substrate according to claim 11, wherein a ratio of the area of the orthographic projection of the second gate on the base substrate to the area of the orthographic projection of the third gate on the base substrate is less than or equal to 1 and greater than or equal to 0.1.

13. The display substrate according to any one of claims 1 to 7, wherein the second gate comprises a conductive material with a high work function.

14. The display substrate according to any one of claims 1 to 7, wherein the second gate comprises a second electrode part and a second lead part connected with each other, and the second lead part is electrically connected with the active layer.

15. The display substrate according to any one of claims 1 to 7, wherein the third gate comprises a conductive material with a low work function, and the conductive material with the low work function comprises at least one of aluminum, silver, and zinc.

16. The display substrate according to any one of claims 1 to 7, wherein the third gate comprises a third electrode part and a third lead part connected with each other, and the third lead part is electrically connected with the first gate.

17. The display substrate according to any one of claims 1 to 7, wherein the first gate comprises a first electrode part and a first lead part connected with the first electrode part, and the first lead part is electrically connected with the second gate.

18. The display substrate according to any one of claims 1 to 7, wherein a material of the active layer comprises a metal oxide, the active layer comprises a channel region, and a shape of the channel region is a straight line shape or an inverted U shape.

19. The display substrate according to any one of claims 1 to 7, further comprising a first connection electrode, wherein the first connection electrode is disposed on a side of the active layer away from the base substrate, and the first connection electrode is connected with the second gate and the active layer.

20. The display substrate according to any one of claims 1 to 7, further comprising a second connection electrode, wherein the second connection electrode is disposed on a side of the active layer away from the base substrate, and the second connection electrode is connected with the first gate and the third gate.

21. A display apparatus, comprising the display substrate according to any one of claims 1 to 20.

22. A manufacturing method for a display substrate, comprising:
forming a second gate and a third gate on a base substrate;
forming an active layer on a side of the second gate and the third gate away from the base substrate;
forming a first gate on a side of the active layer away from the base substrate, wherein an orthographic projection of the first gate on the base substrate, an orthographic projection of the second gate on the base substrate, and an orthographic projection of the third gate on the base substrate are all overlapped with an orthographic projection of the active layer on the base substrate; and
electrically connecting the second gate with the active layer and electrically connecting the third gate with the first gate.
